# EUROPEAN PATENT APPLICATION

(11) **EP 4 739 035 A1**
(43) Date of publication of application: **06.05.2026**
(21) Application number: 25194529.1
(22) Date of filing: 07.08.2025
(51) Int. Cl.: H10D 89/60, H03K 19/003, H10D 84/85

(54) **ELECTROSTATIC DISCHARGE LOCK CIRCUIT FOR OUTPUT DRIVER**

(30) Priority: 05.11.2024 US 202463716243 P; 21.07.2025 US 202519275961
(71) Applicant: MEDIATEK INC., Hsinchu City 30078 (TW)
(72) Inventor: YEN, Shih-Chun, 30078 Hsinchu City (TW); NG, Shao Siang, 30078 Hsinchu City (TW)
(74) Representative: Haseltine Lake Kempner LLP

(57) **Abstract**

The present invention provides a circuitry (200) including an output driver (210) and an ESD lock circuit (250). The output driver (210) includes a first transistor (M1) and a second transistor (M2), wherein the first transistor (M1) is coupled between an I/O pad (202) and a ground voltage, and the second transistor (M2) is coupled between the I/O pad (202) and a supply voltage. The ESD lock circuit (250) is coupled between the I/O pad (202) and the ground voltage, and is configured to generate a control signal to control the first transistor (M1) according to a voltage at the I/O pad (202).

## Description

### Field of the Invention

The present invention relates to an electrostatic discharge lock circuit.

### Background of the Invention

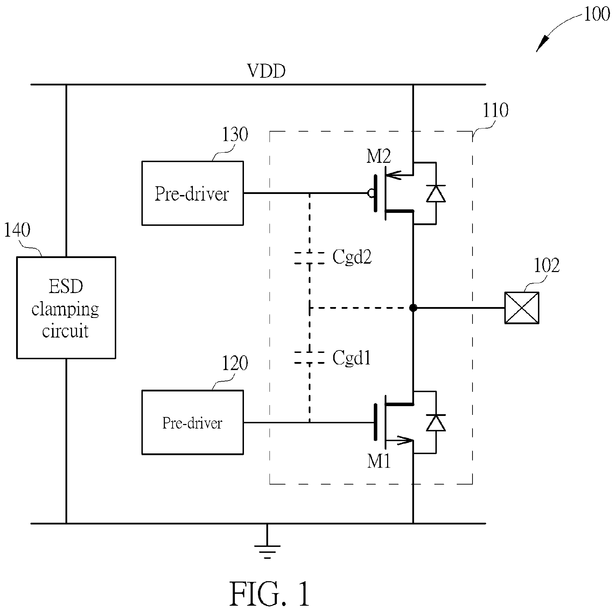

FIG. 1 is a conventional circuitry 100 comprising an output driver 110. As shown in FIG. 1, the circuitry 100 further comprises two pre-drivers 120, 130, an electrostatic discharge (ESD) clamping circuit 140 and an input/output (I/O) pad 102. The output driver 110 comprises an N-type transistor M1 and a P-type transistor M2 connected between a supply voltage VDD and a ground voltage, wherein a connection node coupled between a drain electrode of the P-type transistor M2 and a drain electrode of the N-type transistor M1 is coupled to the I/O pad 102, for receiving an input signal from another device or transmitting an output signal to other devices. The pre-drivers 120 and 130 are configured to enable or disable the N-type transistor M1 and the P-type transistor M2, respectively, to generate the output signal to the other devices via the I/O pad 102. The ESD clamping circuit 140 is configured to provide a current path when the supply voltage VDD is higher than a threshold voltage.

Generally, N-type transistor M1 and the P-type transistor M2 in the output driver 110 are designed to have larger sizes to provide better driving capability or self-protection. However, transistors with larger sizes also have larger gate-drain parasitic capacitances, such as Cgd1 of the N-type transistor M1 and Cgd2 of the P-type transistor M2 shown in FIG. 1. Therefore, if the pad 102 suddenly receives a high voltage, this high voltage will be coupled to the gate electrode of the N-type transistor M1 through the parasitic capacitance Cgd1, which may cause the N-type transistor M1 to be damaged due to this high voltage.

Moreover, since transistors made using current advanced semiconductor processes typically have lower voltage endurance, the likelihood of the N-type transistor being damaged by this high voltage is further increased.

### Summary of the Invention

It is therefore an objective of the present invention to provide circuitry, which design an ESD lock circuit to disable the N-type transistor when the I/O pad suffer high voltage, to solve the above-mentioned problems.

This is achieved by a circuitry according to claim 1. The dependent claims pertain to corresponding further developments and improvements.

As will be seen more clearly from the detailed description following below, a circuitry comprising an output driver and an ESD lock circuit is disclosed. The output driver comprises a first transistor and a second transistor, wherein the first transistor is coupled between an I/O pad and a ground voltage, and the second transistor is coupled between the I/O pad and a supply voltage. The ESD lock circuit is coupled between the I/O pad and the ground voltage, and is configured to generate a control signal to control the first transistor according to a voltage at the I/O pad.

### Brief Description of the Drawings

FIG. 1 is a conventional circuitry comprising an output driver.
FIG. 2 is a diagram illustrating a circuitry according to one embodiment of the present invention.
FIG. 3 shows the ESD lock circuit and the operation of the circuitry show in FIG. 2 when operating in an ESD testing mode according to one embodiment of the present invention.
FIG. 4 shows the ESD lock circuit and the operation of the circuitry show in FIG. 2 when operating in a normal mode according to one embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

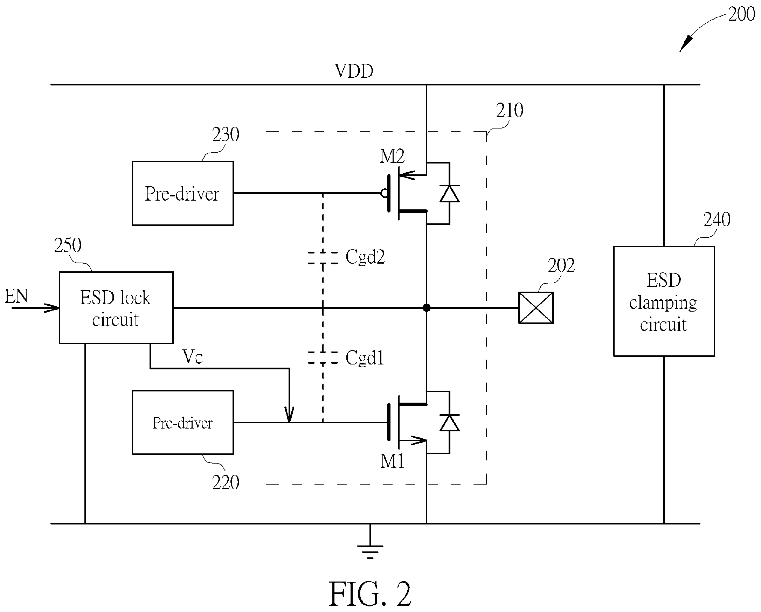

FIG. 2 is a diagram illustrating a circuitry 200 according to one embodiment of the present invention. As shown in FIG. 2, the circuitry 200 comprises an output driver 210, two pre-drivers 220, 230, an ESD clamping circuit 240, an ESD lock circuit 250 and an I/O pad 202. The output driver 210 comprises two transistors M1 and M2 that are implemented by N-type transistor (e.g., N-type Metal Oxide Semiconductor Field Effect Transistors (MOSFETs)) and P-type transistor (e.g., P-type MOSFET), respectively, wherein a source electrode of the transistor M1 is coupled to a ground voltage, a drain electrode of the transistor M1 is coupled to a drain electrode of the transistor M2, a source electrode of the transistor M2 is coupled to a supply voltage VDD, and a connection node coupled between the drain electrode of the transistor M2 and the drain electrode of the transistor M1 is coupled to the I/O pad 202, for receiving an input signal from another device or transmitting an output signal to other devices. The pre-drivers 220 and 230 are configured to enable or disable the transistors M1 and M2, respectively, to generate the output signal to the other devices via the I/O pad 202. The ESD clamping circuit 240 is configured to provide a current path.

In this embodiment, the ESD clamping circuit 240 can have one or more ESD clamping devices, such as diodes, transistors, lateral diffused MOS (LDMOS), silicon controlled rectifier (SCR), etc.

As described in the background of the present invention, if the pad 202 suddenly receives a high voltage (e.g., under an ESD test), this high voltage will be coupled to the gate electrode of the transistor M1 through the parasitic capacitance Cgd1 (i.e., gate-drain parasitic capacitance), which may cause the N-type transistor M1 to be damaged due to this high voltage. In order to solve this problem, the ESD lock circuit 250 is designed within the circuitry 200, so that the gate electrode of the transistor M1 can be controlled to have low voltage. Specifically, the ESD lock circuit 250 is coupled between the I/O pad 202 and the ground voltage (the ESD lock circuit 250 does not connect to the supply voltage VDD), and the ESD lock circuit 250 can be enabled or disabled based on an enable signal EN. When the circuitry 200 operates under an ESD test mode, the ESD lock circuit 250 is enabled, and the ESD lock circuit 250 generates a control signal Vc with low voltage level to the gate electrode of the transistor M1 when the I/O pad 202 has a high voltage, to disable the transistor M1. In addition, when the circuitry 200 operates in a normal mode, the ESD lock circuit 250 is disabled, and the gate electrode of the transistor M1 is controlled by the pre-driver 220.

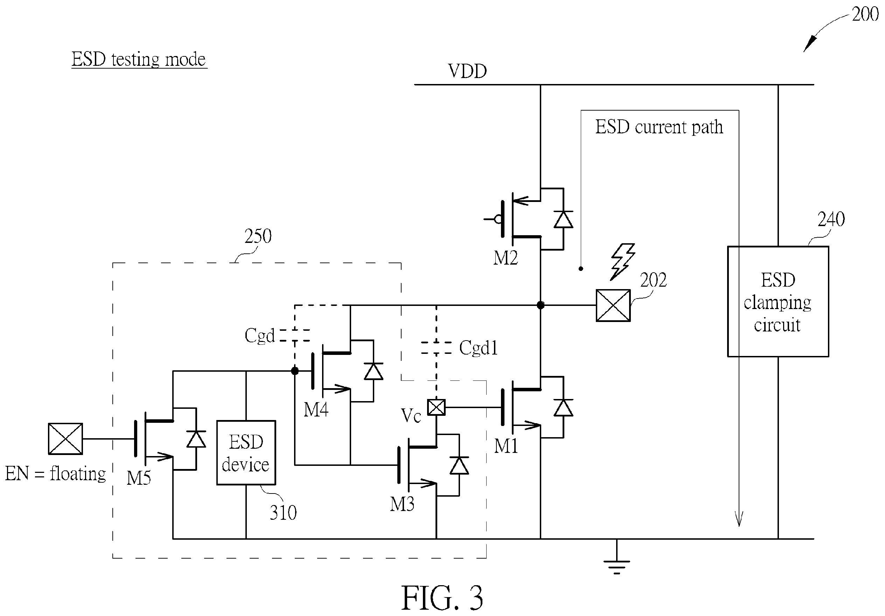

Specifically, refer to FIG. 3, which shows the ESD lock circuit 250 and the operation of the circuitry 200 when operating in an ESD testing mode according to one embodiment of the present invention. As shown in FIG. 3, the ESD lock circuit 250 comprises transistors M3 - M5 and an ESD device 310. The transistor M3 is implemented by an N-type transistor, wherein a drain electrode of the transistor M3 is coupled to the gate electrode of the transistor M1, and a source electrode of the transistor M3 is coupled to the ground voltage. The transistor M4 is implemented by an N-type transistor, wherein a drain electrode of the transistor M4 is coupled to the I/O pad 202, and both a gate electrode and a source electrode of the transistor M4 are coupled to a gate electrode of the transistor M3. The transistor M5 is implemented by an N-type transistor, wherein a source electrode of the transistor M5 is coupled to the gate electrode of the transistor M4, a source electrode of the transistor M5 is coupled to the ground voltage, and a gate electrode of the transistor M5 is configured to receive the enable signal EN. The ESD device 310 is an optional device, which is coupled between the gate electrode of the transistor M4 and the ground voltage.

When the circuitry 200 operates in the ESD testing mode, the circuitry 200 is powered off, and a high voltage is applied to the I/O pad 202. In this embodiment, the enable signal EN is floating and has low voltage level, so that the transistor M5 is disabled. In the operation of the circuitry 200, when the high voltage is applied to the I/O pad 202, the gate electrode of the transistor M4 will receive a coupled signal (with high voltage level) via the parasitic capacitance Cgd, so that the transistor M4 is enabled to make the gate electrode of the transistor M3 also have the high voltage level. Since the transistor M3 is enabled, the drain electrode of the transistor M3 will be pulled low (e.g., close to ground voltage), so that the control signal Vc generated at the drain electrode of the transistor M3 has low voltage level to disable the transistor M1. Therefore, because the transistor M1 is disabled by the ESD lock circuit 250 using the high voltage at the I/O pad 202, the ESD current will flow into ground through the transistor M2 and the ESD clamping circuit 240, to prevent the transistor M1 from being damaged.

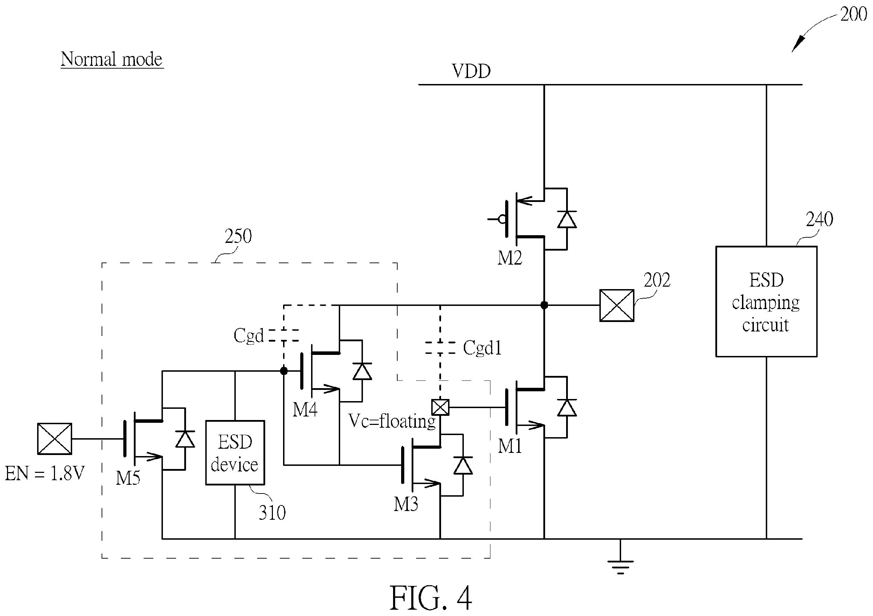

In addition, referring to FIG. 4, when the circuitry 200 operates in the normal mode, the enable signal EN has a high voltage level such as 1.8V to enable the transistor M5. Since the transistor M5 is enabled, the gate electrode of the transistor M4 is forced to have low voltage level such as ground voltage, so that the transistor M3 is disabled. Therefore, because the transistor M3 is disabled, the drain electrode of the transistor M3 can be regarded as at floating state, so the transistor M1 can receive the driving signal from the pre-driver 220 without being affected by the control signal Vc of the ESD lock circuit 250.

It is noted that because the I/O pad 102 does not directly connect to the gate electrode of any of the transistor M4 and M3, the voltage level at the I/O pad 202 when the circuitry 200 operates in the normal mode will not affect the status of the ESD lock circuit 250.

In addition, the transistor M5 shown in FIG. 3 and FIG. 4 can be replaced by a switch with any suitable type. That is, as long as the switch can be disabled to disconnect the gate electrode of the transistor M4 from ground voltage when the circuitry 200 operates in the ESD testing mode, and can be enabled to pull down the gate electrode of the transistor M4 when the circuitry 200 operates in the normal mode, the switch can have another circuit structure.

In the above embodiment, by using the ESD lock circuit 250 to disable the transistor M1 when the circuitry 200 operates in the ESD testing mode, the ESD current path can be controlled to prevent the transistor M1 from being damaged. In addition, because these is no need to design other ESD protection devices between the I/O pad 202 and supply voltage VDD, and no need to design other ESD protection devices between the I/O pad 202 and ground voltage, the circuitry 200 will not suffer leakage currents of these ESD protection device when operating in the normal mode.

## Claims

1. A circuitry (200), comprising:
an output driver (210) comprising a first transistor (M1) and a second transistor (M2), wherein the first transistor (M1) is coupled between an input/output (I/O) pad (202) and a ground voltage, and the second transistor (M2) is coupled between the I/O pad (202) and a supply voltage; and
an electrostatic discharge (ESD) lock circuit (250), coupled between the I/O pad (202) and the ground voltage, configured to generate a control signal to control the first transistor (M1) according to a voltage at the I/O pad (202).

2. The circuitry (200) of claim 1, wherein the circuitry (200) selectively operates in an ESD testing mode or a normal mode; and when the circuitry (100) operates in the ESD testing mode, the ESD lock circuit (250) receives the voltage at the I/O pad (202) to generate the control signal to disable the first transistor (M1).

3. The circuitry (200) of claim 2, further comprising:
two pre-drivers (220, 230);
wherein when the circuitry (200) operates in the normal mode, the ESD lock circuit (250) is disabled, and the two pre-drivers (220, 230) are configured to generate two driving signals to control the first transistor (M1) and the second transistor (M2), to generate an output signal to the I/O pad (202).

4. The circuitry (200) of any preceding claim, wherein the ESD lock circuit (250) comprises:
a third transistor (M3), coupled between a gate electrode of the first transistor (M1) and the ground voltage; and
a fourth transistor (M4), configured to selectively couple the I/O pad (202) to a gate electrode of the third transistor (M3).

5. The circuitry (200) of claim 4, wherein the first transistor (M1), the third transistor (M3) and the fourth transistor (M4) are N-type transistors, a drain electrode of the third transistor (M3) is used to generate the control signal to the gate electrode of the first transistor (M1), a source electrode of the third transistor (M3) is coupled to the ground voltage, a drain electrode of the fourth transistor (M4) is coupled to the I/O pad (202), and a gate electrode and a source electrode of the fourth transistor (M4) are coupled to the gate electrode of the third transistor (M3).

6. The circuitry (200) of claim 5, wherein the gate electrode of the fourth transistor (M4) does not directly connect to the I/O pad (202), and the gate electrode of the fourth transistor (M4) only couples the I/O pad (202) via a parasitic capacitor.

7. The circuitry (200) of claim 5, further comprising:
a switch (M5), configured to selectively couple the gate electrode of the fourth transistor (M4) to the ground voltage.

8. The circuitry (200) of claim 7, wherein the circuitry (200) selectively operates in an ESD testing mode or a normal mode; and when the circuitry (200) operates in the ESD testing mode, the switch (M5) is disabled, and the gate electrode of the fourth transistor (M4) receives a coupled signal with high voltage level via a gate-drain parasitic capacitance of the fourth transistor (M4) when the I/O pad (202) has the voltage with high voltage level, so that the fourth transistor (M4) and the third transistor (M3) are enabled to generate the control signal to disable the first transistor (M1).

9. The circuitry (200) of claim 8, wherein when the circuitry (200) operates in the normal mode, the switch (M5) is enabled, and the fourth transistor (M4) and the third transistor (M3) are disabled so that the drain electrode of the third transistor (M3) is at a floating state.

10. The circuitry (200) of any of claims 7 to 9, wherein the switch (M5) is implemented by the N-type transistor.
